# EUROPEAN PATENT APPLICATION

(11) **EP 3 678 271 A1**
(43) Date of publication of application: **08.07.2020**
(21) Application number: 18859083.0
(22) Date of filing: 21.09.2018
(51) Int. Cl.: H02H 7/18, H02H 3/08, H02J 7/00, G01R 19/165

(54) **POWER SOURCE PROTECTION APPARATUS AND TERMINAL USING SAME**

(30) Priority: 23.09.2017 CN 201710870484
(71) Applicant: Huawei Technologies Co., Ltd., Longgang District Shenzhen, Guangdong 518129 (CN)
(72) Inventor: LIU, Xinyu, Shenzhen, Guangdong 518129 (CN); LIU, Yanding, Shenzhen, Guangdong 518129 (CN); LIU, Ce, Shenzhen, Guangdong 518129 (CN); WANG, Pinghua, Shenzhen, Guangdong 518129 (CN); CAO, Yong, Shenzhen, Guangdong 518129 (CN)
(74) Representative: Maiwald Patent- und Rechtsanwaltsgesellschaft mbH
(86) International application number: PCT/CN2018/106922
(87) International publication number: WO 2019/057148

(57) **Abstract**

A power protection apparatus includes a protection IC, a switch transistor group, and a sampling resistor. The protection IC is respectively connected to a positive electrode and a negative electrode of the cell and includes a mirror current input port, a mirror current output port, an operational amplifier, a voltage regulation switch transistor, and a charge-discharge protection end. The operational amplifier includes a positive input pin, a negative input pin, and an output pin. The voltage regulation switch transistor includes a voltage input pin connected to the output pin of the operational amplifier, a current input pin connected to the mirror current input port, and a current output pin connected to the mirror current output port. The switch transistor group is connected between the positive electrode of the cell and the load and is configured to turn on or turn off a charge-discharge loop of the cell, and the at least one control end is connected to the at least one charge-discharge protection end of the protection IC and is configured to receive a control signal of the protection IC to control the switch transistor group to be turned off to implement abnormity protection of the cell.

## Description

### TECHNICAL FIELD

Embodiments of the present invention relate to the circuit field, and more specifically, to a power protection apparatus and a terminal using the apparatus.

### BACKGROUND

Currently, fast charging of terminals has become a common customer demand, and a fast charging technology used for the terminals has become a current hot technology, but heat generation caused during fast charging is a challenge in the entire industry. When a charging current of a charging circuit is doubled, a quantity of heat generated due to impedance of the same charging circuit changes to four times an original quantity of heat.

During use of lithium ion batteries used by some common terminals, a protective circuit that is packaged inside a battery and that is connected to a cell in series is required, and is configured to monitor charge overvoltage, discharge undervoltage, charge overcurrent, discharge overcurrent of the lithium ion batteries. A discharge overcurrent not only needs to satisfy a requirement of LPS (Limited power sources) authentication of a related specification, that is, a semiconductor switch (MOS) transistor is turned off within five seconds when a current is 8 amperes, to implement power-off protection, but also needs to satisfy a requirement that a mobile phone is not power off in pulse load: within 60 seconds when a current is 5 amperes, within five seconds when a current is 6 amperes, and within two seconds when a current is 7 amperes.

Currently, in current detection methods of a battery protective circuit, a common method is to use resistance impedance of a MOS transistor of a charge-discharge loop for overcurrent detection and use a pressure drop formed when a current flows through a resistor of the MOS transistor of the charge-discharge loop to trigger an overcurrent detection comparator inside a protection IC of a lithium battery. However, resistance of the MOS transistor is not a constant value and changes as various conditions change, and when a large current is used to implement fast charging, a turn-on voltage of two ends of the MOS transistor is relatively high and has a relatively large change range. Consequently, the resistance of the MOS transistor also changes greatly, and therefore cannot meet a high-precision requirement.

Currently, in the current detection methods of a battery protective circuit, another common method is to specially configure a current sampling resistor for a charging circuit, using the current sampling resistor for overcurrent detection, and using a pressure drop formed when a current flows through the current sampling resistor RS of the charge-discharge loop to trigger an overcurrent detection comparator inside a battery protection IC.

However, because an additional current sampling resistor is introduced, impedance of the charge-discharge loop increases. When a large current is used to implement fast charging, the current sampling resistor generates heat. Consequently, heating impact on the charge-discharge loop is significantly increased.

Therefore, currently, it is impossible to find an effective solution that has sufficient precision of overcurrent detection and in which through-current impedance of a charge-discharge loop does not additionally increase when a large current is used to implement fast charging for a battery.

### SUMMARY

Embodiments of the present invention provide a power protection apparatus and a terminal using the apparatus, to resolve a problem that through-current loop impedance is excessively high and precision of overcurrent detection is insufficient when a large current is used to implement fast charging for a battery.

According to a first aspect, an embodiment of the present invention provides a power protection apparatus, configured to protect a cell connected to a load, and including a protection IC, a switch transistor group, and a sampling resistor, where the protection IC includes two power input terminals respectively connected to a positive electrode and a negative electrode of the cell, and further includes a mirror current input port, a mirror current output port, an operational amplifier, a voltage regulation switch transistor, and at least one charge-discharge protection end; the operational amplifier includes a positive input pin, a negative input pin, and an output pin; the voltage regulation switch transistor includes a voltage input pin connected to the output pin of the operational amplifier, a current input pin connected to the mirror current input port, and a current output pin connected to the mirror current output port; the switch transistor group is connected between the positive electrode of the cell and the load and is configured to turn on or turn off a charge-discharge loop of the cell, where the switch transistor group includes a main loop part of the switch transistor group and a sampling part of the switch transistor group, the switch transistor group includes a first connection end connected to the load, a second connection end connected to the positive electrode of the cell, and at least one control end, the first connection end and the second connection end are respectively connected to an input end and an output end, used when the main loop part of the switch transistor group is charged, of the main loop part, and the at least one control end is connected to the at least one charge-discharge protection end of the protection IC and is configured to receive a control signal of the protection IC to control the switch transistor group to be turned off to implement abnormity protection of the cell; one end of the sampling detection resistor Rs is connected to the mirror current output port, the other end of the sampling detection resistor Rs is grounded, and the sampling detection resistor Rs is configured to detect a current of the sampling part of the switch transistor group; the main loop part of the switch transistor group is connected to the positive input pin, and the sampling part of the switch transistor group is connected to the negative input pin; and the operational amplifier is mainly configured to make a voltage of the main loop part of the switch transistor group be the same as a voltage of a joint part between the main loop part and the operational amplifier, so that a current flowing through the main loop is equally proportional to the current flowing through the sampling loop. It can be understood that, in some embodiments, another component may be used to implement an effect that voltages of the at least one sampling loop connection end and a main-loop detection end are the same. Therefore, this embodiment of the present invention is not limited to the operational amplifier; the operational amplifier is only a name limited to a current technology and cognition; and any component or integrated circuit with a similar function should be equivalent to the operational amplifier. The first connection end and the second connection end are respectively equivalently connected to an input end and an output end, used when the main loop part of the switch transistor group is charged, of the main loop part, or an output end and an input end, used when the main loop part of the switch transistor group discharges, of the main loop part. In other words, the main loop part of the switch transistor group forms a part of the charge-discharge loop of the cell, and a current in the charge-discharge loop mainly flows through the main loop through the first connection end and the second connection end.

The protection apparatus mainly uses a current mirroring function of a detection field effect transistor of the switch transistor group to mirror a current in a main through-current loop according to a specific proportionality coefficient 1/K, to obtain a very small current. The protection IC completes detection on the very small current obtained through mirroring, and then a value of the current in the main through-current loop is obtained by multiplying the very small current by the proportionality coefficient K. Finally, according to the value, it can be determined whether there is charge overcurrent or discharge overcurrent, and then the protection IC is used to turn off a charge switch or a discharge switch to complete functions of charge overcurrent protection and discharge overcurrent protection.

With reference to the first aspect, in a first possible implementation of the first aspect, the operational amplifier is configured to make the negative input pin have a same potential as the positive input pin, that is, make the at least one sampling loop connection end have a same potential as the main-loop detection end, so that the current flowing through the sampling loop is equally proportional to the current flowing through the main loop, where a current flowing through the first connection end and the second connection end is equal to the current of the main loop.

With reference to the first aspect or the first implementation of the first aspect, in a second possible implementation of the first aspect, the switch transistor group includes (X+KX) switch transistor units connected in parallel to each other; X switch transistor units are connected in parallel to form the sampling loop; KX transistors are connected in parallel to form the main loop; and a ratio of the current flowing through the sampling loop to the current flowing through the main loop is equal to a ratio of the quantity of switch transistor units in the sampling loop to the quantity of switch transistor units in the main loop, in other words, the ratio is equal to 1: K, where X is an integer value greater than or equal to 1, K is greater than 1, and KX is an integer.

With reference to the second implementation of the first aspect, in a third possible implementation of the first aspect, the switch transistor group includes a sampling output end SS₁ connected to the sampling part of the switch transistor group and a main-loop detection output end S₁ₖ connected to the main loop part of the switch transistor group; S₁ₖ is connected to the negative input pin of the operational amplifier; and SS₁ is connected to both the positive input pin of the operational amplifier and the mirror current input port.

With reference to the third implementation of the first aspect, in a fourth possible implementation of the first aspect, the switch transistor group further includes a sampling output end SS₂ connected to the sampling part of the switch transistor group and a main-loop detection output end S₂ₖ connected to the main loop part of the switch transistor group; and the protection IC further includes a second mirror current input port, a second mirror current output port, a second operational amplifier, and a second voltage regulation switch transistor, where the second voltage regulation switch transistor includes a voltage input pin connected to an output pin of the second operational amplifier, a second current input pin connected to the second mirror current input port, and a second current output pin connected to the second mirror current output port; S₂ₖ is connected to a negative input pin of the second operational amplifier; SS₂ is connected to both a positive input pin of the second operational amplifier and the second mirror current input port; and the power protection apparatus further includes a second sampling detection resistor RS2 connected in series between the second mirror current output port and a ground.

With reference to the second implementation of the first aspect, in a fifth possible implementation of the first aspect, the switch transistor group includes a sampling output end SS₁ and a sampling detection output end SS₁ₖ that are connected to the sampling part of the switch transistor group, and a main-loop detection output end S₁ₖ connected to the main loop part of the switch transistor group, where S₁ₖ is connected to the negative input pin of the operational amplifier, SS₁ is connected to the mirror current input port, and SS₁ₖ is connected to the positive input pin of the operational amplifier.

With reference to the fifth implementation of the first aspect, in a sixth possible implementation of the first aspect, the switch transistor group further includes a sampling output end SS₂ and a sampling detection output end SS₂ₖ that are connected to the sampling part of the switch transistor group, and a main-loop detection output end S₂ₖ connected to the main loop part of the switch transistor group; and the protection IC further includes a second mirror current input port, a second mirror current output port, a second operational amplifier, and a second voltage regulation switch transistor, where the second voltage regulation switch transistor includes a voltage input pin connected to an output pin of the second operational amplifier, a second current input pin connected to the second mirror current input port, and a second current output pin connected to the second mirror current output port; S₂ₖ is connected to a negative input pin of the second operational amplifier; SS₂ is connected to the second mirror current input port; and SS₂ₖ is connected to a positive input pin of the secondary operational amplifier.

With reference to the fifth implementation or the sixth implementation of the first aspect, in a seventh possible implementation of the first aspect, each switch transistor unit includes a first switch transistor Sa and a second switch transistor Sb reversely connected to Sa in series; each Sa is connected in parallel to a diode D1 or each Sb is connected in parallel to a diode D1; Sa is a discharge switch transistor and Sb is a charge switch transistor; the X switch transistor units are connected in parallel together to form the sampling loop; and the KX switch transistor units are connected in parallel together to form the main loop.

With reference to the seventh implementation of the first aspect, in an eighth possible implementation of the first aspect, D poles of all Sas and all Sbs are connected together; G poles of Sas of the (X+KX) switch transistor units are connected together to form a discharge control end G1; G poles of Sbs of the (X+KX) switch transistor units are connected together to form a charge control end G2; S poles of all Sas of the X switch transistor units forming the sampling loop are connected to a same pin to form the sampling loop output end SS1, while S poles of all Sbs of the X switch transistor units are connected to a same pin to form the sampling loop output end SS2; and S poles of all Sas of the KX switch transistor units forming the main loop are connected to a same pin to form the first connection end S1 of the switch transistor group, while S poles of all Sbs of the X switch transistor units are connected to a same pin to form the second connection end S2 of the switch transistor group.

With reference to the eighth implementation of the first aspect, in a ninth possible implementation of the first aspect, SS₁ₖ is formed by directly connecting a high conductivity metal wire to the S poles on wafers of all Sas of the X switch transistor units of the sampling loop; SS₂ₖ is formed by directly connecting a high conductivity metal to the S poles on wafers of all Sbs of the X switch transistor units of the sampling loop; the main-loop detection output end S₁ₖ is formed by directly connecting a high conductivity metal wire to the S poles on wafers of all Sas of the KX switch transistor units of the main loop; and S₂ₖ is formed by directly connecting a high conductivity metal to the S poles on wafers of all Sbs of the KX switch transistor units of the main loop.

With reference to any implementation of the first aspect, in a tenth possible implementation of the first aspect, the at least one control end includes a discharge control end G1 configured to control, during discharging, the switch transistor group to be turned off and a charge control end G2 configured to control, during charging, the switch transistor group to be turned off; and the at least one charge-discharge protection end of the protection IC includes a discharge protection end DO and a charge protection end CO that are correspondingly connected to the discharge control end G1 and the charge control end G2, respectively.

In this embodiment of the present invention, the switch transistor group and the protection IC are combined to implement charge overvoltage protection, discharge undervoltage protection, charge overcurrent protection, and discharge overcurrent protection on a battery; and a current mirroring function of a detection field effect transistor is used to mirror a current in a main through-current loop according to a specific proportionality coefficient 1/K, to obtain a very small current. The protection IC completes detection on the very small current obtained through mirroring, and then a value of the current in the main through-current loop is obtained by multiplying the very small current by the proportionality coefficient K. The sampling detection resistor Rs is connected in series between the sampling detection output end and the output pin and is not located in the charge-discharge loop, and a detection current flowing through the sampling detection resistor Rs is 1/K of a current in the charge-discharge loop and is far less than the current in the charge-discharge loop. Therefore, a very small quantity of heat can also be generated by the sampling detection resistor Rs, thereby causing almost no actual impact on temperature of the charge-discharge loop.

According to a second aspect, an embodiment of the present invention provides a power protection apparatus, configured to protect a cell connected to a load, and including a protection IC, a switch transistor group, and a sampling detection resistor Rs. The protection IC includes two power input terminals respectively connected to a positive electrode and a negative electrode of the cell, a positive current detection end, a negative current detection end, a mirror current input port, a mirror current output port, and at least one charge-discharge protection end. The switch transistor group is connected between the positive electrode of the cell and the load and is configured to turn on or turn off a charge-discharge loop of the cell, where the switch transistor group includes a main loop part and a sampling part; the switch transistor group includes a first connection end connected to the load, a second connection end connected to the positive electrode of the cell, and at least one control end; the first connection end and the second connection end are respectively connected to an input end and an output end, used when the main loop part of the switch transistor group is charged, of the main loop part; and the control end is connected to the at least one charge-discharge protection end of the protection IC and is configured to receive a control signal of the protection IC to control the switch transistor group to be turned off to implement abnormity protection of the cell. One end of the sampling detection resistor Rs is connected to the mirror current output port, the other end of the sampling detection resistor Rs is grounded, and the sampling detection resistor Rs is configured to detect a current of the sampling part of the switch transistor group, where the main loop part of the switch transistor group is connected to the negative current detection end; and the sampling part of the switch transistor group is connected to both the positive current detection end and the mirror current input port. The protection IC may be configured to make a voltage of the main loop part of the switch transistor group be the same as a voltage of a joint part between the main loop part and the operational amplifier, so that a current flowing through the main loop is equally proportional to the current flowing through the sampling loop. It can be understood that, in some embodiments, another component may be used to implement an effect that voltages of the at least one sampling loop connection end and a main-loop detection end are the same. Therefore, this embodiment of the present invention is not limited to the protection IC; the protection IC is only a name limited to a current technology and cognition; and any component or integrated circuit with a similar function should be equivalent to the protection IC. The first connection end and the second connection end are respectively equivalently connected to an input end and an output end, used when the main loop part of the switch transistor group is charged, of the main loop part, or an output end and an input end, used when the main loop part of the switch transistor group discharges, of the main loop part. In other words, the main loop part of the switch transistor group forms a part of the charge-discharge loop of the cell, and a current in the charge-discharge loop flows through the main circuit through the first connection end and the second connection end.

According to a third aspect, an embodiment of the present invention provides a battery, including a cell and the power protection apparatus configured to protect the cell in the first aspect, the second aspect, or any implementation of the first aspect.

According to a fourth aspect, an embodiment of the present invention provides a terminal, including a charging connector, a charging management chip, a battery, and a load, where the charging connector is configured to connect to a charging cable, the charging management chip is connected between the charging connector and the battery, so as to control a charging process of the battery, and the battery is configured to supply power to the load, where the battery includes a cell and the power protection apparatus configured to protect the cell in the first aspect, the second aspect, or any implementation of the first aspect.

In the embodiments of the present invention, the switch transistor group and the protection IC are combined to implement charge overvoltage protection, discharge undervoltage protection, charge overcurrent protection, and discharge overcurrent protection on a battery; and a current mirroring function of a detection field effect transistor is used to mirror a current in a main through-current loop according to a specific proportionality coefficient 1/K, to obtain a very small current. The protection IC of a lithium battery completes detection on the very small current obtained through mirroring, and then a value of the current in the main through-current loop is obtained by multiplying the very small current by the proportionality coefficient K. The sampling detection resistor Rs is connected in series between the sampling loop detection end and the output pin and is not located in the charge-discharge loop, and a detection current flowing through the sampling detection resistor Rs is 1/K of a current in the charge-discharge loop and is far less than the current in the charge-discharge loop. Therefore, a very small quantity of heat can also be generated by the sampling detection resistor Rs, thereby causing almost no actual impact on temperature of the charge-discharge loop.

In addition, a current flowing through the at least one sampling loop connection end and the sampling detection resistor Rs is far less than a current flowing through the main loop of the switch transistor group and the charge-discharge loop. Therefore, although a value of the sampling detection resistor Rs is tens of ohms to hundreds of ohms, a loss with actual impact is not generated on the sampling detection resistor Rs, and that the resistance value of the sampling detection resistor Rs is not affected by factors such as heat facilitates selection of an appropriate resistance value to obtain maximum detection precision.

Finally, it is determined, based on the detection current, whether there is charge overcurrent or discharge overcurrent, and then the protection IC is used to turn off a charge switch or a discharge switch to complete functions of charge overcurrent protection and discharge overcurrent protection. In this way, high-precision charge overcurrent protection and discharge overcurrent protection can be implemented without configuring a current sampling resistor in a charge-discharge through-current loop of the terminal, and can further greatly reduce through-current loop impedance and effectively reduce heat generation of the charge-discharge loop.

### BRIEF DESCRIPTION OF DRAWINGS

FIG. 1 is an application scenario diagram according to an embodiment of the present invention;
FIG. 2 is a circuit diagram of a power protection apparatus according to Embodiment 1 of the present invention;
FIG. 3 is another circuit diagram of a power protection apparatus according to Embodiment 1 of the present invention;
FIG. 4 is a schematic structural diagram of a switch transistor group according to an embodiment of the present invention;
FIG. 5 is a schematic structural diagram of another switch transistor group according to an embodiment of the present invention;
FIG. 6 is a schematic structural diagram of still another switch transistor group according to an embodiment of the present invention;
FIG. 7 is a circuit diagram of a power protection apparatus according to Embodiment 2 of the present invention;
FIG. 8 is another circuit diagram of a power protection apparatus according to Embodiment 2 of the present invention;
FIG. 9 is a circuit diagram of a power protection apparatus according to Embodiment 3 of the present invention;
FIG. 10 is another circuit diagram of a power protection apparatus according to Embodiment 3 of the present invention;
FIG. 11 is a circuit diagram of a power protection apparatus according to Embodiment 4 of the present invention; and
FIG. 12 is another circuit diagram of a power protection apparatus according to Embodiment 4 of the present invention.

### DESCRIPTION OF EMBODIMENTS

The following clearly and completely describes technical solutions in the embodiments of the present invention with reference to accompanying drawings in the embodiments of the present invention.

A power protection apparatus in the embodiments of the present invention is mainly applicable to various electronic products with rechargeable batteries, and in particular, to some portable devices, for example, terminal products such as a mobile phone, a tablet computer, a notebook computer, and various wearable devices. For such terminals that need to be charged, a power protection apparatus is required to perform power-off protection to prevent overvoltage, overcurrent, overcharge, and the like; otherwise, due to overvoltage, overcurrent, overcharge, and the like, a cell in a battery is damaged and even serious consequences such as cell explosion is caused. A battery in the embodiments of the present invention includes a charging protection circuit or a charging protection apparatus and a cell, where the cell is an electric energy storage carrier such as a dry battery.

For ease of description, an electronic product with a rechargeable battery is referred to as a terminal in the following.

The power protection apparatus in the embodiments of the present invention may be used as a lithium battery protection circuit of a consumer electronic device, for example, a lithium battery protection circuit of a mobile phone, various wearable devices such as a watch, a notebook computer, a tablet computer, and the like, where the lithium battery protection circuit exists on an independent printed circuit board (PCB), and the PCB is connected to a cell of a lithium battery. A rechargeable battery in a consumer electronic product usually refers to a lithium battery package formed by a PCB carrying a lithium battery protection circuit, a cell of a lithium battery, and a housing and is used to supply power to the consumer electronic device.

The power protection apparatus in the embodiments of the present invention mainly includes a MOS transistor group and a protection integrated circuit (IC). The MOS transistor group and the protection integrated circuit are combined to implement charge overvoltage protection, discharge undervoltage protection, charge overcurrent protection, and discharge overcurrent protection on a battery. An advantage of the power protection apparatus is that high-precision charge overcurrent protection and discharge overcurrent protection can be implemented without configuring a current sampling resistor in a charge-discharge through-current loop of a terminal, so as to greatly reduce through-current loop impedance and reduce heat generation. The power protection apparatus mainly uses a current mirroring function of a detection field effect transistor to mirror a current in a main through-current loop according to a specific proportionality coefficient 1/K, to obtain a very small current. A protection IC of a lithium battery completes detection on the very small current obtained through mirroring, and then a value of the current in the main through-current loop is obtained by multiplying the very small current by the proportionality coefficient K. Finally, according to the value, it can be determined whether there is charge overcurrent or discharge overcurrent, and then the protection IC is used to turn off a charge switch or a discharge switch to complete functions of charge overcurrent protection and discharge overcurrent protection.

A current mirroring principle of the detection field effect transistor used in the embodiments of the present invention is that small switch transistor units inside a switch transistor group are allocated on a same wafer according to a specific proportion, for example, switch transistor units are allocated according to a proportion of 1X/1000X, 1000X switch transistor units in the proportion of 1/1000 are used for main-loop through-current, and IX switch transistor units in the proportion of 1/1000 is used for current sampling. When voltages at output pins of two parts of switch transistor units for main-loop through-current and current sampling are equal, because temperature characteristics on the same wafer are the same, a proportion of overall impedance of the two parts of switch transistor units for main-loop through-current and current sampling should also be 1:1000. In addition, two-end voltages of the two parts of switch transistor units for main-loop through-current and current sampling are also the same, and therefore a ratio of currents flowing through the two parts for main-loop through-current and current sampling is 1000:1.

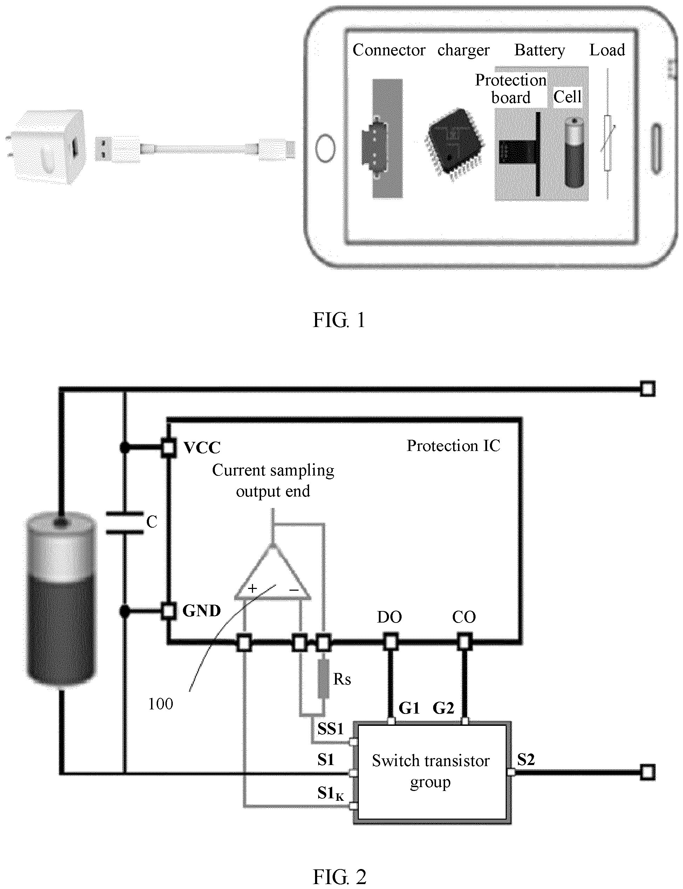

As shown in FIG. 1, in an embodiment of the present invention, a terminal using the power protection apparatus includes a connector connected to a charger through a cable, a charging management chip, a power protection apparatus, a battery cell, and a load, where the power protection apparatus is a protection board of the battery, and the load may be any electrical component in the terminal, such as a display, a communications module, a processor, a memory, a sensor, a loudspeaker, or another electrical component.

When the terminal is charged, a current flow direction is as follows: the charger → the cable → the connector → the charging management chip → the power protection apparatus → the cell. When the terminal discharges, a current flow direction is as follows: the cell → the protection board → the load.

In a charging process of the terminal, components that limit a charging current include the charger, the charging management chip, and the protection board. When the charger or the charging management chip fails, or both fail at the same time, charge overcurrent protection of the cell needs to be completed by the protection board, and when charge overcurrent is detected, a switch element on the protection board is turned off, and a charging path is cut off.

In a discharging process, a component that limits a discharging current is the protection board. When the load is abnormal, for example, the load is short-circuited, discharge overcurrent protection of a lithium battery is completed by the protection board, and when discharge overcurrent is detected, a switch element on the protection board is turned off, and a discharging path is cut off.

### Embodiment 1

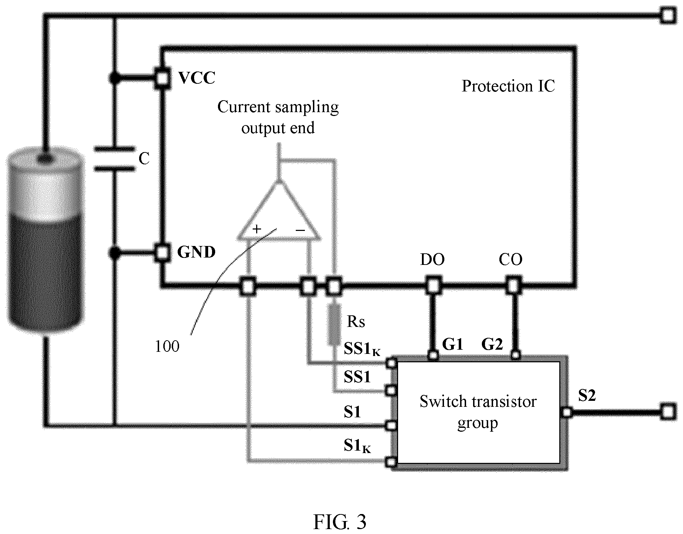

Referring to both FIG. 2 and FIG. 3, a terminal with a charging protection function is provided, and the terminal includes a cell, a power protection apparatus, and a load supplied with power by using the cell. The power protection apparatus mainly includes a protection IC connected to the cell and a switch transistor group configured to perform turn-on protection and turn-off protection on the cell.

The protection IC includes a power terminal VCC connected to a positive electrode of the cell, a ground terminal GND connected to a negative electrode of the cell, a positive current detection end T1, a negative current detection end T2, a current sampling detection output end, a discharge protection end DO, and a charge protection end CO, where the power terminal VCC and the ground terminal GND are two power input terminals of the protection IC, and are respectively connected to the positive electrode and the negative electrode of the cell. The IC protection circuit includes an operational amplifier 100, and the operational amplifier 100 includes a positive input pin connected to the positive current detection end T1, a negative input pin connected to the negative current detection end, and an output pin connected to the current sampling detection output end. The positive electrode and the negative electrode of the cell may be further connected to a filter capacitor C that is configured to filter an interference current and an interference voltage.

The switch transistor group is connected in series between the negative electrode of the cell and the load, and includes a first connection end S₁ connected to the negative electrode of the cell and a second connection end S₂ connected to the load. The switch transistor group further includes a discharge control end G1 configured to control, during discharging, the switch transistor group to be turned off and a charge control end G2 configured to control, during charging, the switch transistor group to be turned off. The discharge control end G1 and the charge control end G2 are correspondingly connected to the discharge protection end DO and the charge protection end CO of the protection IC, respectively.

The switch transistor group further includes a sampling loop formed by connecting X switch transistor units of a sampling part in parallel and a main loop formed by connecting KX switch transistor units of a main loop part in parallel, where X is an integer greater than or equal to 1, and K is a value greater than 1. Theoretically, to pursue a relatively ideal effect, X is suitable for being set to an appropriate value, for example, X is an integer value greater than or equal to 1. For example, within values in [1, 10000], the value of X may be set to 100, 1000, 3000, 5000, or another value, while K is greater than or equal to 100. For example, the value of K may be set to 100, 500, 1000, 5000, 10000, or another value greater than 1. Theoretically, a larger value of K leads to higher accuracy, and KX is an integer value. Specifically, repeated comparative tests may be performed according to a technology and based on costs and a crystal property to obtain a value of K that not only can make through-current impedance of the power protection apparatus be small enough and but also can obtain sufficient overcurrent protection precision. The first connection end S₁ and the second connection end S₂ are respectively equivalently connected to an input end and an output end, used when the main loop part of the switch transistor group is charged, of the main loop part, or an output end and an input end, used when the main loop part of the switch transistor group discharges, of the main loop part. In other words, the main loop part of the switch transistor group forms a part of a charge-discharge loop of the cell, and a current in the charge-discharge loop mainly flows through the main loop through the first connection end S1 and the second connection end S2.

The switch transistor group further includes at least one sampling loop connection end connected to a connection end of the sampling loop and a main-loop detection end connected to an input end or an output end of the main loop, where the main-loop detection end is connected to the positive input pin, and the at least one sampling loop connection end is connected to the negative input pin.

In this embodiment, the at least one sampling loop connection end includes the sampling loop output end SS₁, and the main-loop detection end includes a main loop detection output end S₁ₖ. The sampling loop output end SS₁ is connected to the negative input pin of the operational amplifier 100 through the negative current detection end of the protection IC. The main-loop detection output end S₁ₖ is connected to the positive input pin of the operational amplifier 100 through the positive current detection end T1 of the protection IC.

The sampling circuit output end SS₁ is further connected to an output pin of the operational amplifier 100, while the output pin is connected to the current sampling detection output end of the protection IC. The power protection apparatus further includes a sampling detection resistor Rs, where the sampling detection resistor Rs is connected in series between the sampling loop output end SS₁ and the output pin of the operational amplifier 100 and is configured to generate a sampling detection current. The cell, the switch transistor group, and the load form a charge-discharge loop that is a main conduction loop for cell discharging and charging.

Specially referring to FIG. 3, in some embodiments, to increase a precision requirement, the at least one sampling loop connection end further includes a sampling detection output end SS₁ₖ connected to the sampling loop; the sampling loop output end SS₁ is connected to only the output pin of the operational amplifier 100, while the sampling detection output end SS₁ₖ is connected to the negative input pin of the operational amplifier 100; and the sampling detection resistor Rs is connected in series between the sampling loop output end SS₁ and the output pin of the operational amplifier 100.

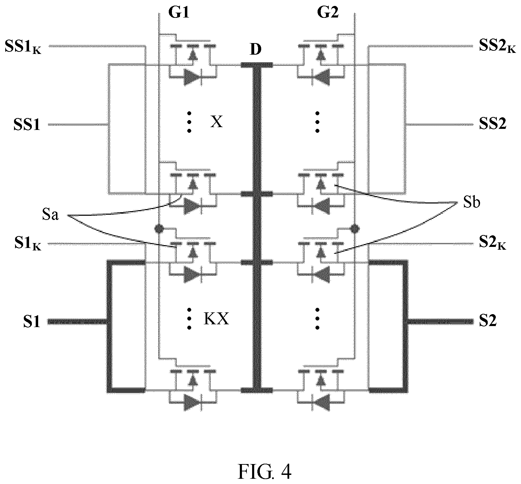

As shown in FIG. 4, the switch transistor group includes (X+KX) switch transistor units connected in parallel to each other; X MOS switch transistor units are connected in parallel to form the sampling loop; KX MOS transistors are connected in parallel to form the main loop; each switch transistor unit includes a first switch transistor Sa and a second switch transistor Sb reversely connected to Sa in series; each Sa is connected in parallel to a diode D1 or each Sb is connected in parallel to a diode D1; either of Sa and Sb is a charge switch transistor and the other one is a discharge switch transistor. In this embodiment, for ease of description, Sa is selected as a discharge switch transistor, and is turned on when the cell discharges and is turned off when the cell discharges; Sb is selected as a charge switch transistor, and is turned on when the cell is charged and is turned off when the cell discharges. D1 is configured to protect Sa and Sb to prevent Sa and Sb from being broke down. Sa and Sb each may be a MOS transistor or may be another semiconductor switch transistor with a similar characteristic.

The X switch transistor units are connected in parallel together to form the sampling loop, while the KX switch transistor units are connected in parallel together to form the main loop, where D poles of Sas and Sbs of the (X+KX) switch transistor units are connected together; G poles of Sas of the (X+KX) switch transistor units are connected together to form the discharge control end G1; and G poles of Sbs of the (X+KX) switch transistor units are connected together to form the charge control end G2.

S poles of all Sas of the X switch transistor units forming the sampling loop are connected to a same pin, and the pin forms the sampling loop output end SS₁ though a lead, while S poles of all Sbs of the X switch transistor units are connected to a same pin, and the pin forms the sampling loop output end SS₂ though a lead.

Similar to the sampling loop, S poles of all Sas of the KX switch transistor units forming the main loop are connected to a same pin, and the pin forms the first connection end S1 of the switch transistor group though a lead, while S poles of all Sbs of the X switch transistor units are connected to a same pin, and the pin forms the second connection end S2 of the switch transistor group though a lead. Currents flowing through the first connection end S₁ and the second connection end S₂ are equal to a current flowing through the main loop, that is, equal to a sum of currents flowing through the KX switch transistor units of the main loop.

To reduce impact of impedance of the pin and improve detection precision, the sampling detection output end SS₁ₖ of the switch transistor group may be formed by directly connecting a high conductivity metal wire to the S poles on wafers of all Sas of the X switch transistor units of the sampling loop. Similarly, the other sampling detection output end SS₂ₖ of the switch transistor group may be formed by directly connecting a high conductivity metal to the S poles on wafers of all Sbs of the X switch transistor units of the sampling loop.

Similar to the sampling loop, the main-loop detection output end S₁ₖ may be formed by directly connecting a high conductivity metal wire to the S poles on wafers of all Sas of the KX switch transistor units of the main loop. Similarly, the other main-loop detection output end S₂ₖ of the switch transistor group may be formed by directly connecting a high conductivity metal to the S poles on wafers of all Sbs of the KX switch transistor units of the main loop.

The high conductivity metal wires include high conductivity metal wires such as a gold wire, a silver wire, and a copper wire, or may include some high conductivity alloy conductors. A current is imported directly from a wafer of the switch transistor group through a high conductivity metal wire, without passing through a pin, so as to avoid impact of impedance of the pin on precision of current detection.

It can be understood that, in some embodiments, in some cases in which a detection precision requirement is not very high or current detection precision can completely satisfy a requirement, the sampling detection output ends SS₁ₖ and SS₂ₖ and the main-loop detection output ends S₁ₖ and S₂ₖ do not need to be formed through direct extension from wafers of transistors of the switch transistor group through high conductivity metal wires, but output ends SS₁, SS₂, S₁, and S₂ formed by pins of the switch transistor group are directly used. In addition, in some embodiments, the main-loop detection end may be the first connection end S1 connected to all Sas of the main loop of the switch transistor group and the second connection end Sb connected to all Sbs of the main loop of the switch transistor group.

In some embodiments, positions of Sa and Sb may be exchanged; the operational amplifier 100 may alternatively be connected to another side of the switch transistor group, that is, the switch transistor may be connected to SS₂, SS₂ₖ, and S₂ₖ; a difference in these connection manners does not change an implementation principle and an implementation. Details are not described herein.

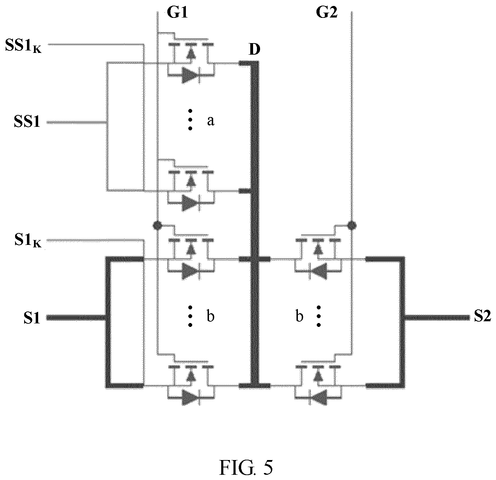

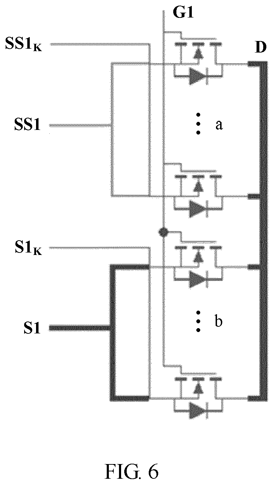

In some embodiments of the present invention, the switch transistor group is not limited to a case in which each switch transistor unit shown in FIG. 4 includes Sa and Sb. As shown in FIG. 5, the switch transistor group is a unilateral switch transistor group, and each switch transistor unit includes only one switch transistor, and only cell charging or discharging is protected. Alternatively, as shown in FIG. 6, in some embodiments of the present invention, the switch transistor group is a bilateral switch transistor group, but only each switch transistor unit of a main loop part of the switch transistor group includes two switch transistors reversely connected in series, while each switch unit of a sampling loop part of the switch transistor group includes only one switch transistor. It can be learned that the switch transistor group in the embodiments of the present invention is not limited to a specific structure design, any switch transistor group that can implement the following may be used as a switch transistor group in the embodiments of the present invention: When voltages of a main loop and a sampling loop are equal, there is a mirror relationship that currents are equally proportional to each other.

The operational amplifier 100 is configured to adjust a potential of the negative input pin to be the same as a potential of the positive input pin, that is, to make the sampling detection output end SS₁ₖ of the switch transistor group have a same potential as the main-loop detection output end S₁ₖ. Because MOS transistor units forming the switch transistor group are located on a same wafer; consistency of the units is very high, temperature characteristics of the units are also very consistent, and impedance of the units is also consistent, a voltage between the discharge control end G1 and the sampling detection output end SS₁ₖ of the switch transistor group is equal to a voltage between the discharge control end G1 and the main-loop detection output end S₁ₖ, and a voltage between a D pole of a switch transistor of the sampling loop and SS₁ₖ is equal to a voltage between a D pole of a switch transistor of the main loop and S₁ₖ; in other words, V_{G1SS1k}=V_{G1S1K} and V_{DSS1k}=V_{DS1K}. A relationship between resistance R_{DSS1k} between the D pole of the switch transistor of the sampling loop and the sampling detection output end SS₁ₖ and resistance R_{DS1k} between the D pole of the switch transistor of the main loop and the main-loop output end S₁ₖ is R_{DSS1k}:R_{DS1k}=K:1; in other words, a ratio between impedance of the main loop and the sampling loop of the switch transistor group is equal to an inverse ratio 1/k of a quantity of MOS transistor units connected in parallel of the main loop to a quantity of MOS transistor units connected in parallel of the sampling loop.

When V_{G1SS1k}=V_{G1S1K}, R_{DSS1k}:R_{DS1k}=K:1. When a current of the sampling detection output end SS₁ₖ is I _{SS1k}, and a current of the main-loop output end S₁ₖ is I_{S1k}, I_{SS1k}:I_{S1k}=1/1/(R_{DSS1k}:R_{DS1k})=1:K; in other words, the current I_{SS1k} of the sampling loop is a mirror current obtained by dividing the current I_{S1k} of the main loop by K. Therefore, I_{S1k}=K^{∗}I_{SS1k} can be obtained according to a mirroring proportionality coefficient K by detecting the current I_{SS1k} of the sampling loop.

When K is large enough, for example, when K is greater than or equal to 100, 1000, or 10000, I_{S1k} is basically equal to a current I_{S1} flowing through the switch transistor group and the entire charge-discharge loop, and I_{SS1k} is basically equal to the current Issi flowing through the sampling loop, and therefore I_{SS1}/I_{S1}=1/K. The protection IC determines, based on a value of I_{S1k}, whether to send a turn-off signal to the discharge control end G1 and the charge control end G2 of the switch transistor group, to turn off the switch transistor group to stop cell charging or discharging.

A mirroring principle of connection ends extending from the part Sb, such as S₂, S₂ₖ, and SS₂ₖ, is the same as that of S₁, S₁ₖ, and SS₁ₖ. Details are as follows:

When V_{G1SS1k}=V_{G1S1K}, R_{DSS1k}:R_{DS1k}=K:1. When a current of the sampling detection output end SS₂ₖ is I_{SS2k}, and a current of the main-loop output end S₂ₖ is I_{S2k}, I_{SS2k}:I_{S2k}=1/1/(R_{DSS2k}:R_{DS2k})=1:K; in other words, the current I_{SS2k} of the sampling loop is a mirror current obtained by dividing the current I_{S2k} of the main loop by K. Therefore, I_{S1k}=K^{∗}I_{SS1k} can be obtained based on a mirroring proportionality coefficient K by detecting the current I_{SS1k} of the sampling loop.

It can be understood that characteristics and working principles of the part Sa and the part Sb in the switch transistor group are completely consistent, only conduction directions are opposite to each other. For simplicity, only a key point is simply described herein, and specific implementation details are not detailed.

In this embodiment of the present invention, the switch transistor group and the protection IC are combined to implement charge overvoltage protection, discharge undervoltage protection, charge overcurrent protection, and discharge overcurrent protection on a battery; and a current mirroring function of a detection field effect transistor is used to mirror a current in a main through-current loop according to a specific proportionality coefficient 1/K, to obtain a very small current. The protection IC of a lithium battery completes detection on the very small current obtained through mirroring, and then a value of the current in the main through-current loop is obtained by multiplying the very small current by the proportionality coefficient K. The sampling detection resistor Rs is connected in series between the sampling detection output end SS₁ₖ and the output pin and is not located in the charge-discharge loop, and a detection current flowing through the sampling detection resistor Rs is 1/K of a current in the charge-discharge loop and is far less than the current in the charge-discharge loop. Therefore, a very small quantity of heat can also be generated by the sampling detection resistor Rs, thereby causing almost no actual impact on temperature of the charge-discharge loop.

In addition, a current flowing through the sampling detection output end SS₁ₖ and the sampling detection resistor Rs is far less than a current flowing through the main loop of the switch transistor group and the charge-discharge loop. Therefore, although a value of the sampling detection resistor Rs is tens of ohms to hundreds of ohms, a loss with actual impact is not generated on the sampling detection resistor Rs, and that the resistance value of the sampling detection resistor Rs is not affected by factors such as heat facilitates selection of an appropriate resistance value to obtain maximum detection precision.

Finally, it is determined, based on the detection current, whether there is charge overcurrent or discharge overcurrent, and then the protection IC is used to turn off a charge switch or a discharge switch to complete functions of charge overcurrent protection and discharge overcurrent protection. In this way, high-precision charge overcurrent protection and discharge overcurrent protection can be implemented without configuring a current sampling resistor in a charge-discharge through-current loop of a terminal, and can further greatly reduce through-current loop impedance and effectively reduce heat generation of the charge-discharge loop.

In addition, based on suitable values of the foregoing mirror detection current and the sampling detection resistor Rs, precision of a reference voltage of a comparator that is configured to determine overcurrent and that is in the power protection apparatus may achieve a level of X mV±2 mV. For example, when the precision of the reference voltage is 200 mV±2 mV, an error caused due to the precision of the reference voltage of the comparator that is configured to determine overcurrent and that is in the power protection apparatus is only 1%. For another example, when design is performed according to turn-off overcurrent protection implemented within a time of 3.5 seconds (S) based on a threshold of 7±0.7 amperes (A), protection can be implemented within 5s at 8 A, while no turn-off protection is implemented within 60s at 5 A, within 5s at 6 A, and within 2s at 7 A. 0.7 A means precision of 10% relative to 7 A, in the error 10%, an error caused due to precision of the protection IC may reach within 1%, an error caused due to precision of a current sampling resistor may reach within 1%, an error caused due to precision of a current mirroring proportion of a MOS transistor group may reach within 5%, and the foregoing errors are added up to achieve an objective less than 10%.

When a voltage of a second end of the sampling detection resistor Rs, that is, an amplitude value of a measured signal, is higher than a reference voltage of a comparator that is configured to determine overcurrent and that is in the protection IC, an output end of the comparator outputs a first level, and further the switch transistor group is turned off, indicating that there is overcurrent in the charge-discharge loop and the switch transistor group; otherwise, the output end of the comparator outputs a second level to keep the switch transistor group on, indicating that there is no overcurrent in the charge-discharge loop and the switch transistor group.

In some embodiments, the power protection apparatus may be configured to perform current or voltage abnormity protection on a power supply or a device other than the cell. In an abnormal case in which a detection current of the power supply or the device is excessively large or excessively small, a protective measure such as turn-off, voltage reduction, or voltage boosting is taken.

### Embodiment 2

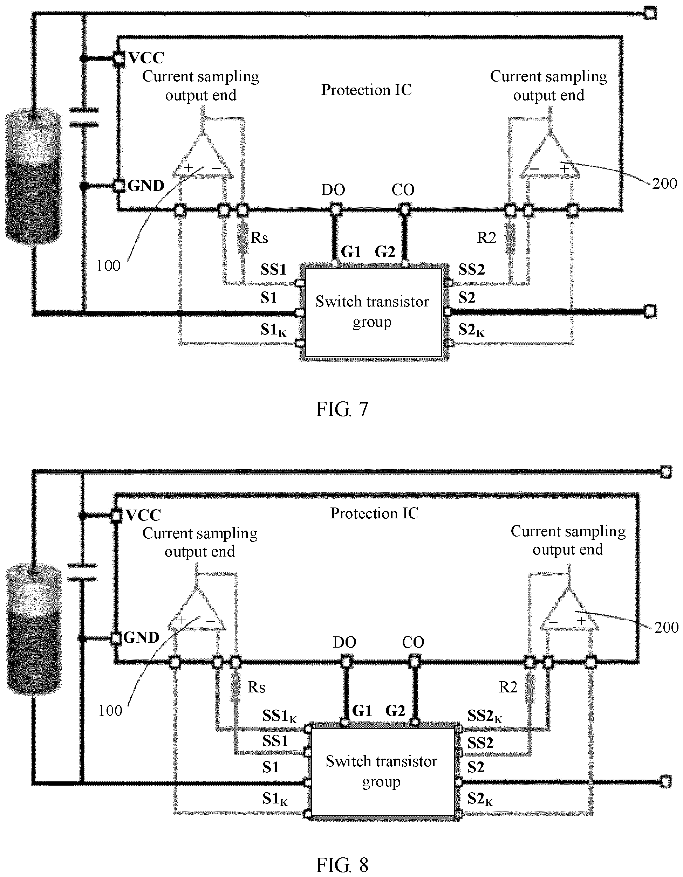

As shown in FIG. 7, a difference between a power protection apparatus in Embodiment 2 of the present invention and the power protection apparatus in Embodiment 1 lies in that: The power protection apparatus in Embodiment 1 is provided with only one operational amplifier 100, and the operational amplifier 100 is connected to only an output end of a discharge switch transistor Sa in the switch transistor group, while in Embodiment 2, a secondary operational amplifier 200 is further included based on Embodiment 1, and the operational amplifier 200 is connected to an output end of a charge switch transistor Sb in the switch transistor group. Details are as follows:

Based on Embodiment 1, the protection IC further includes a positive current detection end, a negative current detection end, and a current sampling detection output end.

The secondary operational amplifier 200 also includes a positive input pin connected to the positive current detection end, a negative input pin connected to the negative current detection end, and an output pin connected to the current sampling detection output end.

A sampling loop output end SS₂ of the switch transistor group is connected to the negative input pin of the secondary operational amplifier 200 through the negative current detection end of the protection IC, and the main loop detection output end S₂ₖ is connected to the positive input pin of the secondary operational amplifier 200 through the positive current detection end of the protection IC.

The sampling loop output end SS₂ is connected to the output pin of the secondary operational amplifier 200, and the output pin is connected to the current sampling detection output end of the protection IC. The power protection apparatus further includes a sampling detection resistor Rs, and the sampling detection resistor Rs is connected in series between the sampling loop output end SS₂ of the switch transistor group and the output pin of the secondary operational amplifier 200 and is configured to generate a sampling detection current.

Connection of the secondary operational amplifier 200 in Embodiment 2 of the present invention is similar to that of the operational amplifier 100 in Embodiment 1, and a delicate difference therebetween has been described above. Current detection and overcurrent protection principles of a charge-discharge loop in Embodiment 2 of the present invention are exactly the same as those in Embodiment 1, and details are not described herein again.

As shown in FIG. 8, in some embodiments of the present invention, to increase a precision requirement, the sampling loop output end SS2 is connected to only the output pin of the secondary operational amplifier 200, while the sampling detection output end SS₂ₖ is connected to the negative input pin of the secondary operational amplifier 200, and the sampling detection resistor Rs is connected in series between the sampling loop output end SS2 and the output pin of the secondary operational amplifier 200.

It can be understood that, in some embodiments, the protection IC is provided with only one secondary operational amplifier 200 connected to an output end of a discharge switch transistor Sb in the switch transistor group. This can also implement the present invention, to use a mirror current as a sampling detection current to detect a charge-discharge current value of a cell, and to control turn-off of the switch transistor group based on the charge-discharge current value obtained through sampling detection and a comparison result of a comparator, to implement abnormity protection of the cell, such as overcurrent protection and overheat protection.

### Embodiment 3

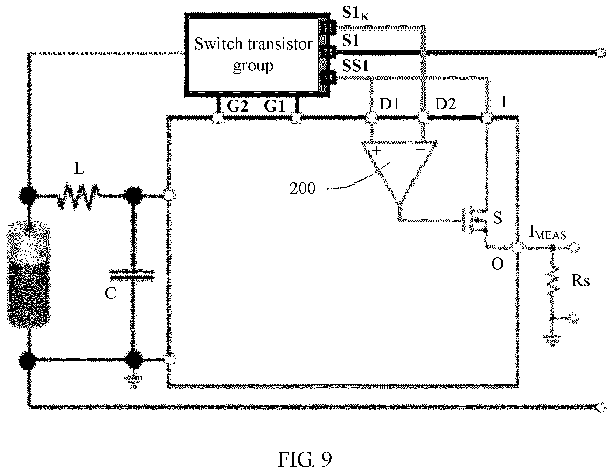

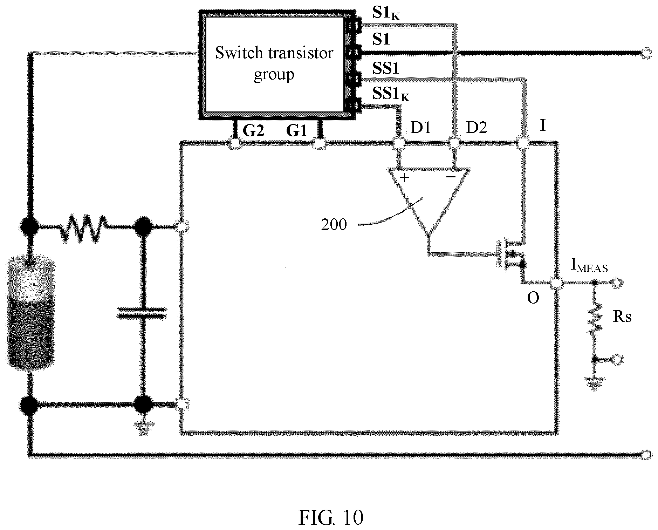

As shown in FIG. 9 and FIG. 10, a main difference between Embodiment 3 and Embodiments 1 and 2 of this application lies in that: A switch transistor group of a power protection apparatus in Embodiment 3 is connected between a positive electrode of a cell and a load, while the switch transistor group in each of Embodiments 1 and 2 is connected between the negative electrode of the cell and the load.

The power protection apparatus in Embodiment 3 of this application mainly includes a protection IC connected to the cell and the switch transistor group configured to perform turn-on protection and turn-off protection on the cell, where a structure and a function of the switch transistor group are the same as those of the switch transistor group in each of Embodiments 1 and 2, and a specific function and structure of the switch transistor group are not described herein again.

The protection IC includes a power terminal VCC connected to the positive electrode of the cell, a ground terminal GND connected to a negative electrode of the cell, a positive current detection end T1, a negative current detection end T2, a mirror current input port I, a mirror current output port O, a discharge protection end DO, and a charge protection end CO, where the power terminal VCC and the ground terminal GND are two power input terminals of the protection IC, and are respectively connected to the positive electrode and the negative electrode of the cell. The IC protection circuit includes an operational amplifier 200 and a voltage regulation switch transistor S. The operational amplifier 200 includes a positive input pin connected to the positive current detection end T1, a negative input pin connected to the negative current detection end T2, and an output pin for outputting an adjustable voltage. The operational amplifier 200 adjusts a value of the adjustable voltage output by the output pin to make a voltage of a sampling loop of the switch transistor be equal to a voltage output by a main loop, that is, make a voltage of S₁ₖ be equal to a voltage of SS₁ or SS₁ₖ.

The voltage regulation switch transistor S includes a voltage input pin connected to the output pin of the operational amplifier 200, a current input pin connected to the mirror current input port I, and a current output pin connected to the mirror current output port O.

The power protection apparatus may further include a filter capacitor C connected between the power terminal VCC and the ground terminal GND and a filter inductor connected between the power terminal VCC and the positive electrode of the cell, to perform filtering processing on an interference current and an interference voltage to reduce interference and improve precision and reliability.

A discharge protection end DO and a charge protection end CO of the protection IC are respectively connected to a discharge control end G1 and a charge control end G2 for controlling turn-off of the switch transistor group. It can be understood that in some embodiments, because the switch transistor group has different structures, only the discharge protection end DO of the protection IC and the discharge control end G1 correspondingly connected to the discharge protection end DO or the charge protection end CO of the protection IC and the charge control end G2 correspondingly connected to charge protection end CO need to be configured to implement charge protection or discharge protection on the cell.

The positive input pin of the operational amplifier 200 is connected to SS₁ or SS₁ₖ of the sampling loop of the switch transistor group through the positive current detection end T1 of the protection IC, and the negative input pin of the operational amplifier is connected to S₁ₖ of the main loop of the switch transistor group through the negative current detection end T2. The power protection apparatus further includes a sampling detection resistor Rs, where one end of the sampling detection resistor Rs is connected to the mirror current output port O of the protection IC, and the other end of the sampling detection resistor Rs is grounded. A value of the mirror current may be calculated by detecting a voltage of the sampling detection resistor Rs, so as to obtain a value of a current of the main loop of the switch transistor group, that is, a value of a current, in a charge-discharge loop of the cell, flowing through the switch transistor group.

The power protection apparatus further includes a filter capacitor C and a filter inductor L, configured to filter an interference current and an interference voltage. The filter inductor L is connected in series between the power terminal VCC of the operational amplifier 200 and the positive electrode of the cell; two ends of the filter inductor L are respectively connected to the power terminal VCC and the ground terminal GND; one end, connected to the power terminal VCC, of the filter inductor L is also connected to one end of the filter inductor L; and the other end, connected to the ground terminal GND, of the filter inductor L is connected to the negative electrode of the cell and is also grounded. It should be noted that the grounding means a zero level reference point, and is not limited to being grounded.

An operating principle of the operational amplifier 200 is basically the same as the operating principle of the operational amplifier 100 in each of Embodiments 1 and 2, and the operational amplifier 200 is configured to adjust a potential of the negative input pin to be the same as a potential of the positive input pin, that is, to make the sampling detection output end SS₁ₖ or the sampling loop output end SS₁ of the switch transistor group have a same potential as the main-loop detection output end S₁ₖ. An only difference is in adjusted circuit structures and adjustment manners. For example, the switch transistor group in each of Embodiments 1 and 2 is connected between the negative electrode of the cell and the load, and the output pin of the operational amplifier directly adjusts an output voltage, so that the negative input pin has a same potential as the positive input pin. However, the switch transistor group in this embodiment is connected between the positive electrode of the cell and the load. Not only output of the output pin needs to be adjusted to make the sampling detection output end SS₁ₖ and the main-loop detection output end S₁ₖ of the switch transistor group have a same potential, but also to ensure that potentials of the sampling detection output end SS₁ₖ and the main-loop detection output end S₁ₖ of the switch transistor group is positive, the output pin is connected to the sampling resistor Rs through the voltage regulation switch transistor S, and one end of the sampling resistor Rs is connected to the voltage regulation switch transistor S and the other end of the sampling resistor Rs is grounded. The operational amplifier 200 adjusts a voltage output by the output pin, that is, adjusts a turn-on voltage of the voltage regulation switch transistor S, to adjust on resistance of the voltage regulation switch transistor S, so as to adjust a voltage of the sampling loop output end SS₁ to make the sampling detection output end SS₁ₖ or the sampling loop output end SS₁ and the main-loop detection output end S₁ₖ of the switch transistor group have a same potential.

Because MOS transistor units forming the switch transistor group are located on a same wafer, consistency of the units is very high, temperature characteristics of the units are also very consistent, and impedance of the units is also consistent, a voltage between the discharge control end G1 and the sampling detection output end SS₁ₖ or SS₁ of the switch transistor group is equal to a voltage between the discharge control end G1 and the main-loop detection output end S₁ₖ, and a voltage between a D pole of a switch transistor of the sampling loop and SS₁ₖ or SS₁ is equal to a voltage between a D pole of a switch transistor of the main loop and S₁ₖ; in other words, V_{G1SS1k}=V_{G1S1K} and V_{DSS1k}=V_{DS1K}. A relationship between resistance R_{DSS1k} between the D pole of the switch transistor of the sampling loop and the sampling detection output end SS₁ₖ and resistance R_{DS1k} between the D pole of the switch transistor of the main loop and the main-loop output end S₁ₖ is R_{DSS1k}:R_{DS1k}=K:1; in other words, a ratio between impedance of the main loop and the sampling loop of the switch transistor group is equal to an inverse ratio 1/k of a quantity of MOS transistor units connected in parallel of the main loop to a quantity of MOS transistor units connected in parallel of the sampling loop.

When V_{G1SS1k}=V_{G1S1K}, R_{DSS1k}:R_{DS1k}=K:1. When a current of the sampling detection output end SS₁ₖ is I_{SS1k}, and a current of the main-loop output end S₁ₖ is I_{S1k}, I_{SS1k}:I _{S1k}=1/1/(R_{DSS1k}:R_{DS1k})=1:K; in other words, the current I_{SS1k} of the sampling loop is a mirror current obtained by dividing the current I_{S1k} of the main loop by K. Therefore, I_{S1k}=K^{∗}I_{SS1k} can be obtained according to a mirroring proportionality coefficient K by detecting the current I_{SS1k} of the sampling loop.

### Embodiment 4

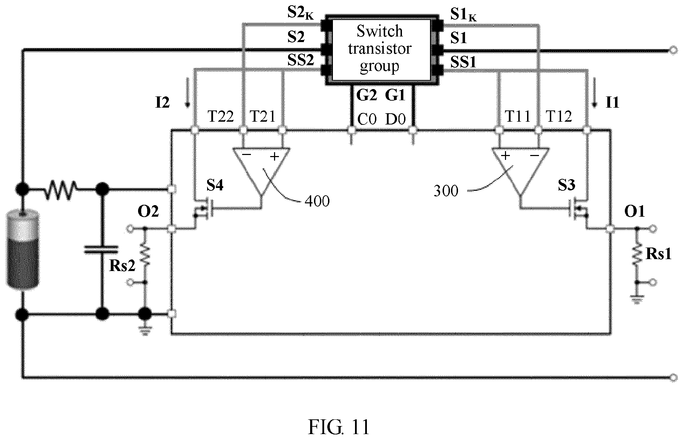

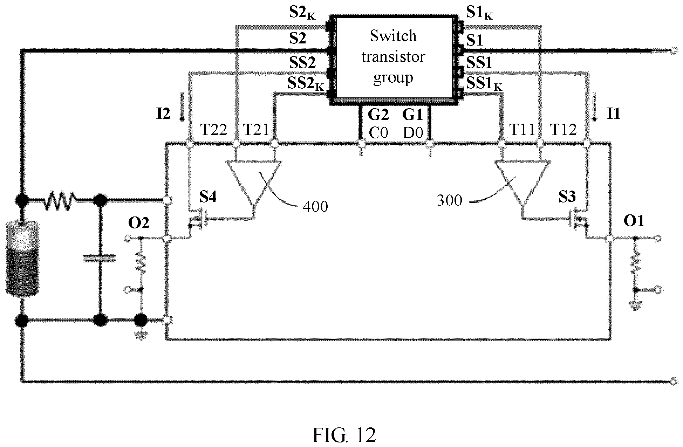

As shown in FIG. 11 and FIG. 12, a main difference between Embodiment 4 and Embodiment 3 of this application lies in that: The switch transistor group of the power protection apparatus in Embodiment 3 is used for only discharge or charge protection of the cell, or in other words, the protection IC in Embodiment 3 is provided with only one operational amplifier, and is connected to some switch transistors that are responsible for charging or discharging turn-on and that are in the switch transistor group. In Embodiment 4, a first operational amplifier 300 and a second operational amplifier 400 are respectively connected to all first switch transistors Sa and all second switch transistors Sb that are responsible for charging or discharging turn-on and that are in the switch transistor group, to perform overcurrent detection and turn-off protection for discharging and charging of the cell.

A power protection apparatus in Embodiment 4 of this application mainly includes a protection IC connected to the cell and a switch transistor group configured to perform turn-on protection and turn-off protection on the cell, where a structure and a function of the switch transistor group are the same as or similar to those in Embodiment 1, Embodiment 2, and Embodiment 3, and a specific structure and function of the switch transistor group are not described herein again.

The protection IC includes a power terminal VCC connected to a positive electrode of the cell, a ground terminal GND connected to a negative electrode of the cell, a first positive current detection end T11, a first negative current detection end TT12, a first mirror current input port 11, a first mirror current output port O1, a second positive current detection end D21, a second negative current detection end T22, a second mirror current input port 12, a second mirror current output port O2, a discharge protection end DO, and a charge protection end CO, where the power terminal VCC and the ground terminal GND are two power input terminals of the protection IC, and are respectively connected to the positive electrode and the negative electrode of the cell.

The protection IC further includes a first voltage regulation switch transistor S3 and a second voltage regulation switch transistor S4, and the power protection apparatus further includes a first sampling detection resistor Rs1 and a second sampling detection resistor Rs2, where a connection manner between the first operational amplifier 300 and each of the first voltage regulation switch transistor S3, the first sampling detection resistor Rs1, the first positive current detection end, the first negative current detection end, the first mirror current input port, the first mirror current output port, and the switch transistor group is correspondingly the same as a connection manner between the first operational amplifier 200 and each of the voltage regulation switch transistor S, the sampling detection resistor Rs, the positive current detection end T1, the negative current detection end T2, the mirror current input port I, and the mirror current output port O, and the switch transistor group in Embodiment 3. Details are not described herein again.

A connection manner between the second operational amplifier 400 and each of the second voltage regulation switch transistor S4, the second sampling detection resistor Rs2, the second positive current detection end D21, the second negative current detection end T22, the second mirror current input port 12, and the second mirror current output port O2, and the switch transistor group are basically correspondingly the same as a connection manner between the first operational amplifier 300 and each of the first voltage regulation switch transistor S3, the first sampling detection resistor Rs1, the first positive current detection end T11, the first negative current detection end TT12, the first mirror current input port I1, and the first mirror current output port 01, and the switch transistor group; and a difference only lies in that: The first operational amplifier 300 is connected to ports such as S₁, S₁ₖ, SS₁, and SS₁ₖ on one side of the switch transistor group, and the second operational amplifier 400 is symmetrically connected to ports such as S₂, S₂ₖ, SS₂, and SS₂ₖ on the other side of the switch transistor group.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A power protection apparatus, configured to protect a cell connected to a load, and comprising:
a protection IC, comprising two power input terminals respectively connected to a positive electrode and a negative electrode of the cell, wherein the protection IC comprises a mirror current input port, a mirror current output port, an operational amplifier, a voltage regulation switch transistor, and at least one charge-discharge protection end; the operational amplifier comprises a positive input pin, a negative input pin, and an output pin; the voltage regulation switch transistor comprises a voltage input pin connected to the output pin of the operational amplifier, a current input pin connected to the mirror current input port, and a current output pin connected to the mirror current output port;
a switch transistor group, connected between the positive electrode of the cell and the load and configured to turn on or turn off a charge-discharge loop of the cell, wherein the switch transistor group comprises a main loop part of the switch transistor group and a sampling part of the switch transistor group; the switch transistor group comprises a first connection end connected to the load, a second connection end connected to the positive electrode of the cell, and at least one control end; the first connection end and the second connection end are respectively connected to an input end and an output end, used when the main loop part of the switch transistor group is charged, of the main loop part; and the at least one control end is connected to the at least one charge-discharge protection end of the protection IC and is configured to receive a control signal of the protection IC to control the switch transistor group to be turned off to implement abnormity protection of the cell; and
a sampling detection resistor Rs, wherein one end of the sampling detection resistor Rs is connected to the mirror current output port, the other end of the sampling detection resistor Rs is grounded, and the sampling detection resistor Rs is configured to detect a current of the sampling part of the switch transistor group, wherein
the input end or the output end of the main loop part of the switch transistor group is connected to the positive input pin, and a connection end of the sampling part of the switch transistor group is connected to the negative input pin.

2. The power protection apparatus according to claim 1, wherein the operational amplifier is configured to make the negative input pin have a same potential as the positive input pin, so that the current flowing through the sampling part of the switch transistor group is equally proportional to a current flowing through the main loop part of the switch transistor group.

3. The power protection apparatus according to claim 1 or 2, wherein the switch transistor group comprises (X+KX) switch transistor units connected in parallel to each other; X switch transistor units are connected in parallel to form the sampling part of the switch transistor group; KX transistors are connected in parallel to form the main loop part of the switch transistor group; and a ratio of the current flowing through the sampling part of the switch transistor group to the current flowing through the main loop part of the switch transistor group is equal to a ratio of the quantity of switch transistor units in the sampling part of the switch transistor group to the quantity of switch transistor units in the main loop part of the switch transistor group, in other words, the ratio is equal to 1: K, wherein X is an integer value greater than or equal to 1, K is greater than 1, and KX is an integer.

4. The power protection apparatus according to claim 3, wherein the switch transistor group comprises a sampling output end SS₁ connected to the connection end of the sampling part and a main-loop detection output end S₁ₖ connected to the input end, used when the main loop part of the switch transistor group is charged, of the main loop part; S₁ₖ is connected to the negative input pin of the operational amplifier; and SS₁ is connected to both the positive input pin of the operational amplifier and the mirror current input port.

5. The power protection apparatus according to claim 4, wherein the switch transistor group further comprises a sampling output end SS₂ connected to the connection end of the sampling part and a main-loop detection output end S₂ₖ connected to the output end, used when the main loop part of the switch transistor group is charged, of the main loop part; and the protection IC further comprises a second mirror current input port, a second mirror current output port, a second operational amplifier, and a second voltage regulation switch transistor, wherein the second voltage regulation switch transistor comprises a voltage input pin connected to an output pin of the second operational amplifier, a second current input pin connected to the second mirror current input port, and a second current output pin connected to the second mirror current output port; S₂ₖ is connected to a negative input pin of the second operational amplifier; SS₂ is connected to both a positive input pin of the second operational amplifier and the second mirror current input port; and the power protection apparatus further comprises a second sampling detection resistor RS2 connected in series between the second mirror current output port and a ground.

6. The power protection apparatus according to claim 3, wherein the switch transistor group comprises a sampling output end SS₁ and a sampling detection output end SS₁ₖ that are connected to the connection end of the sampling part, and a main-loop detection output end S₁ₖ connected to the input end, used when the main loop part of the switch transistor group is charged, of the main loop part, wherein S₁ₖ is connected to the negative input pin of the operational amplifier, SS₁ is connected to the mirror current input port, and SS₁ₖ is connected to the positive input pin of the operational amplifier.

7. The power protection apparatus according to claim 6, wherein the switch transistor group further comprises a sampling output end SS₂ and a sampling detection output end SS₂ₖ that are connected to the connection end of the sampling part, and a main-loop detection output end S₂ₖ connected to the output end, used when the main loop part of the switch transistor group is charged, of the main loop part; and the protection IC further comprises a second mirror current input port, a second mirror current output port, a second operational amplifier, and a second voltage regulation switch transistor, wherein the second voltage regulation switch transistor comprises a voltage input pin connected to an output pin of the second operational amplifier, a second current input pin connected to the second mirror current input port, and a second current output pin connected to the second mirror current output port; S₂ₖ is connected to a negative input pin of the second operational amplifier; SS₂ is connected to the second mirror current input port; and SS₂ₖ is connected to a positive input pin of the secondary operational amplifier.

8. The power protection apparatus according to claim 6 or 7, wherein each switch transistor unit comprises a first switch transistor Sa and a second switch transistor Sb reversely connected to Sa in series; each Sa is connected in parallel to a diode D1 and each Sb is connected in parallel to a diode D1; either of Sa and Sb is a charge switch transistor and the other one is a discharge switch transistor; the X switch transistor units are connected in parallel together to form the sampling part of the switch transistor group; and the KX switch transistor units are connected in parallel together to form the main loop part of the switch transistor group.

9. The power protection apparatus according to claim 8, wherein the control end comprises a discharge control end G1 and a charge control end G2; D poles of all Sas and all Sbs of the (X+KX) switch transistor units are connected together; G poles of all Sas of the (X+KX) switch transistor units are connected together to form G1; G poles of all Sbs of the (X+KX) switch transistor units are connected together to form G2; S poles of all Sas of the X switch transistor units forming the sampling part of the switch transistor group are connected to a same pin to form the sampling output end SS1, while S poles of all Sbs of the X switch transistor units are connected to a same pin to form the sampling output end SS2; and S poles of all Sas of the KX switch transistor units forming the main loop part of the switch transistor group are connected to a same pin to form the first connection end of the switch transistor group, while S poles of all Sbs of the X switch transistor units are connected to a same pin to form the second connection end of the switch transistor group.

10. The power protection apparatus according to claim 9, wherein the sampling detection output end SS₁ₖ is formed by directly connecting a high conductivity metal wire to the S poles on wafers of all Sas of the X switch transistor units of the sampling part of the switch transistor group; the sampling detection output end SS₂ₖ is formed by directly connecting a high conductivity metal to the S poles on wafers of all Sbs of the X switch transistor units of the sampling circuit of the switch transistor group; the main-loop detection output end S₁ₖ is formed by directly connecting a high conductivity metal wire to the S poles on wafers of all Sas of the KX switch transistor units of the main loop part of the switch transistor group; and the main-loop detection output end S₂ₖ is formed by directly connecting a high conductivity metal to the S poles on wafers of all Sbs of the KX switch transistor units of the main loop part of the switch transistor group.

11. The power protection apparatus according to any one of claims 1 to 8, wherein the at least one control end comprises a discharge control end G1 configured to control, during discharging, the switch transistor group to be turned off and a charge control end G2 configured to control, during charging, the switch transistor group to be turned off; and the at least one charge-discharge protection end of the protection IC comprises a discharge protection end DO and a charge protection end CO that are correspondingly connected to the discharge control end G1 and the charge control end G2, respectively.

12. A power protection apparatus, configured to protect a cell connected to a load, and comprising:
a protection IC, comprising two power input terminals respectively connected to a positive electrode and a negative electrode of the cell, a positive current detection end, a negative current detection end, a mirror current input port, a mirror current output port, and at least one charge-discharge protection end;
a switch transistor group, connected between the positive electrode of the cell and the load and configured to turn on or turn off a charge-discharge loop of the cell, wherein the switch transistor group comprises a main loop part and a sampling part; the switch transistor group comprises a first connection end connected to the load, a second connection end connected to the positive electrode of the cell, and at least one control end; the first connection end and the second connection end are respectively connected to an input end and an output end, used when the main loop part of the switch transistor group is charged, of the main loop part; and the control end is connected to the at least one charge-discharge protection end of the protection IC and is configured to receive a control signal of the protection IC to control the switch transistor group to be turned off to implement abnormity protection of the cell; and
a sampling detection resistor Rs, wherein one end of the sampling detection resistor Rs is connected to the mirror current output port, the other end of the sampling detection resistor Rs is grounded, and the sampling detection resistor Rs is configured to detect a current of the sampling part of the switch transistor group, wherein
the input end or the output end of the main loop part of the switch transistor group is connected to the negative current detection end; and a connection end of the sampling part of the switch transistor group is connected to the positive current detection end and the mirror current input port.

13. The power protection apparatus according to claim 12, wherein the protection IC is configured to make the negative current detection end have a same potential as the positive current detection end, so that the current flowing through the sampling part of the switch transistor group is equally proportional to a current flowing through the main loop part of the switch transistor group.

14. The power protection apparatus according to claim 12 or 13, wherein the switch transistor group comprises (X+KX) switch transistor units connected in parallel to each other; X switch transistor units are connected in parallel to form the sampling part of the switch transistor group; KX transistors are connected in parallel to form the main loop part of the switch transistor group; and a ratio of the current flowing through the sampling part of the switch transistor group to the current flowing through the main loop part of the switch transistor group is equal to a ratio of the quantity of switch transistor units in the sampling part of the switch transistor group to the quantity of switch transistor units in the main loop part of the switch transistor group, in other words, the ratio is equal to 1: K, wherein X is an integer value greater than or equal to 1, K is greater than 1, and KX is an integer.

15. The power protection apparatus according to claim 14, wherein the switch transistor group comprises a sampling output end SS₁ connected to the connection end of the sampling part and a main-loop detection output end S₁ₖ connected to the input end, used when the main loop part of the switch transistor group is charged, of the main loop part; S₁ₖ is connected to a current sampling detection output end of the protection IC; SS₁ is connected to both the negative current detection end and the current sampling detection output end of the protection IC; and the sampling detection resistor Rs is connected in series between SS₁ and the current sampling detection output end of the protection IC.

16. The power protection apparatus according to claim 14, wherein the switch transistor group comprises a sampling output end SS₁ and a sampling detection output end SS₁ₖ that are connected to the connection end of the sampling part, and a main-loop detection output end S₁ₖ connected to the input end, used when the main loop part of the switch transistor group is charged, of the main loop part; S₁ₖ is connected to a current sampling detection output end of the protection IC; SS₁ is connected to a current sampling detection output end of the protection IC; SS₁ₖ is connected to the negative current detection end of the protection IC; and the sampling detection resistor Rs is connected in series between SS₁ and the current sampling detection output end of the protection IC.

17. The power protection apparatus according to any one of claims 14 to 16, wherein each switch transistor unit comprises a switch transistor or two switch transistors that are connected in anti-parallel to each other; each of at least one switch transistor is connected in parallel to a diode D1; the X switch transistor units are connected in parallel together to form the sampling part of the switch transistor group; and the KX switch transistor units are connected in parallel together to form the main loop part of the switch transistor group.

18. The power protection apparatus according to claim 17, wherein D poles of all switch transistors are connected together; G poles of all switch transistors connected in parallel to each other are connected together to form the control end; S poles of all switch transistors connected in parallel to each other together in the X switch transistor units forming the sampling part of the switch transistor group are connected to a same pin to form the sampling output end SS1 connected to the sampling part of the switch transistor; and S poles of all switch transistors connected in parallel to each other together in the KX switch transistor units forming the main loop part of the switch transistor group are connected to a same pin to form the first connection end or the second connection end of the switch transistor group.

19. The power protection apparatus according to claim 18, wherein the sampling detection output end SS₁ₖ is formed by directly connecting a high conductivity metal wire to the S poles on wafers of all the switch transistors connected in parallel to each other together in the X switch transistor units of the sampling part of the switch transistor group; and the detection output end S₁ₖ is formed by directly connecting a high conductivity metal wire to S poles on wafers of all Sas or all Sbs of the KX switch transistor units of the main loop part of the switch transistor group.

20. A battery, wherein the battery comprises a cell and the power protection apparatus configured to protect the cell according to any one of claims 1 to 18.

21. A terminal, comprising a connector, a charging management chip, a battery, and a load, wherein the connector is configured to connect to a charging cable, the charging management chip is connected between the connector and the battery and is configured to control a charging process of the battery, and the battery is configured to supply power to the load, wherein the battery comprises a cell and the power protection apparatus configured to protect the cell according to any one of claims 1 to 18.
